# EUROPEAN PATENT SPECIFICATION

(11) **EP 3 845 934 B1**
(45) Date of publication and mention of the grant of the patent: **23.07.2025**
(21) Application number: 19853661.7
(22) Date of filing: 23.08.2019
(51) Int. Cl.: G02B 5/00, G03F 1/64, G02B 1/113, G02B 1/12

(54) **OPTICAL MEMBER AND METHOD FOR PRODUCING SAME**
OPTISCHES ELEMENT UND VERFAHREN ZUR HERSTELLUNG DAVON
ÉLÉMENT OPTIQUE ET SON PROCÉDÉ DE PRODUCTION

(30) Priority: 31.08.2018 JP 2018162970
(43) Date of publication of application: 07.07.2021
(73) Proprietor: Nippon Light Metal Co., Ltd., Minato-ku Tokyo 105-0004 (JP)
(72) Inventor: IIZUKA Akira, Shizuoka-shi Shizuoka 421-3203 (JP); OSHIMA, Takeshi, Shizuoka-shi Shizuoka 421-3203 (JP); NAKANO, Koichi, Shizuoka-shi Shizuoka 421-3203 (JP)
(74) Representative: Mewburn Ellis LLP
(86) International application number: PCT/JP2019/033094
(87) International publication number: WO 2020/045293

(56) References cited:
- WO-A1-2010/026853
- JP-A- 2000 121 825
- JP-A- 2006 243 044
- JP-A- 2009 169 380
- JP-A- 2010 154 783
- KR-A- 20100 076 690
- US-A1- 2007 066 053
- US-A1- 2011 164 297

## Description

### TECHNICAL FIELD

The present invention relates to a method for producing an optical member, and an optical member produced by the method.

### PRIOR ARTS

The optical members used for various optical components (housing, various supports inside the housing, shutter blades, aperture, etc.) that make up optical devices such as digital cameras, digital video cameras, and mobile phones with cameras require lightweight and, in addition, low light reflectance of the surface, and thus the blackness of the surface is generally increased.

Further, with regard to the pellicle frame for the pellicle, which is an optical component used in the lithography process, by making the surface of the frame black or dark, it is possible to more easily and surely perform a foreign object non-adhesion inspection before use. That is, from the viewpoint of inspectability, the surface of the pellicle frame is required to be black or dark.

Further, these optical components may be maintained in a high temperature environment, and if the distortion due to thermal expansion is large, the optical components cannot sufficiently exhibit their performance. In particular, with regard to exposure equipment, under the demand for productivity improvement (throughput), the wavelength of the exposure light source is becoming shorter due to the increase in light source output and the miniaturization of circuit line width, and thus, there rises a distortion problem due to the temperature rise in the optical member that composes the optical path.

Conventionally, though aluminum has been used for an optical member because of its low specific gravity and good cutting processing, an optical member made of aluminum is liable to be distorted due to the temperature rise, because aluminum has a high linear expansion coefficient. Considering these problems, the material of the optical member is not limited to aluminum, and the use of ceramics, steel, or the like has also being studied.

For example, in Patent Literature 1 (JP 2016-177120 A), there is disclosed a pellicle frame formed in a frame shape, wherein the pellicle frame is composed of a sintered body having a Young's modulus of 150 GPa or more and a Vickers hardness of 800 or more, the corner portion in the frame shape is secured to have a width equal to or larger than the width of the straight portion, and at least one of the corner portions is wider than the width of the straight portion, and the pellicle frame is made of ceramics, cemented carbide or cermet.

Since the pellicle frame described in Patent Literature 1 uses a sintered body having a high Young's modulus and Vickers hardness, it is possible to suppress the deformation due to the film tension generated when the pellicle film is stretched and provided on the pellicle frame. Moreover, it is said that, since the width of at least one corner portion is wider than the width of the straight portion, the strength of the corner portion can be increased, and the deformation and damage of the pellicle frame can be further suppressed.

Further, in Patent Literature 2 (JP 2014-085453 A), there is disclosed a pellicle frame manufactured by press working from a single metal flat plate and has an L-shaped cross section, wherein the pellicle frame has a pellicle film adhesive surface on an outer surface bent at a right angle toward the outside from the inner wall surface of the pellicle frame and a mask adhesive surface on an end surface in contact with an inner wall surface, and the pellicle frame is made of carbon steel or stainless-steel.

It is said that, since the pellicle frame described in Patent Literature 2 is a pellicle frame manufactured by press working having excellent mass productivity, the manufacturing cost is extremely low, and since the pellicle frame is formed into the L-shaped cross section or the U-shaped cross section, the necessary and sufficient rigidity can be secured as a pellicle frame.

### CITATION LIST

### Patent Literature

Patent Literature 1: JP 2016-177120 A
Patent Literature 2: JP 2014-085435 A
Patent Literature 3: KR 1020100076690 A proposes a shape memory alloy pellicle frame.
Patent Literature 4: US 20070066053 A1 proposes a method for producing a substrate having a carbon-doped. titanium oxide layer.

### SUMMARY OF INVENTION

### Technical Problem

However, the pellicle frame described in Patent Document 1 is made of a material having poor toughness and is very brittle, so that it is difficult to handle. Further, the workability is poor and the manufacturing cost becomes high. In addition, cemented carbide and cermet have a high specific gravity, which increases the weight of the pellicle frame.

Further, although the pellicle frame described in Patent Literature 2 can be manufactured at low cost, carbon steel and stainless steel have a high specific gravity, and the weight of the pellicle frame increases. In addition, it is difficult to sufficiently blacken the surface of the pellicle frame.

Considering the above problems in the prior art, an object of the present invention is to provide a lightweight optical member that can be produced at a relatively low cost, wherein distortion due to temperature rise is suppressed, and the appearance color is sufficiently blackened or darkened, and a method for efficiently producing the optical member. Particularly, an object of the present invention is to provide a lightweight pellicle frame that can be manufactured at a relatively low cost, wherein distortion due to temperature rise is suppressed, and the appearance color is sufficiently blackened or darkened from the viewpoint of inspectability, and a method for efficiently producing the optical member.

### Solution to Problem

As a result of extensive study with respect to the optical member in order to achieve the above object, the present inventors have found that it is extremely effective in using titanium or a titanium alloy as a raw material and forming a carbon-doped titanium oxide layer on the surface, the present invention has been completed.

Namely, the present invention provides an optical member according to claim 3.

Since the optical member of the present invention has the base member made of titanium or a titanium alloy, the linear expansion coefficient is lower than that of aluminum, and distortion at the time of temperature rise is effectively suppressed. Further, since titanium or a titanium alloy has a smaller specific gravity than that of steel or cemented carbide, the weight of the optical member can be made lighter. In addition, since titanium or a titanium alloy is a metallic material and has excellent toughness as compared with ceramics and cemented carbide, it is easy to handle. Moreover, because of the good processing ability, it is possible to reduce the production cost and to impart high dimensional accuracy to the optical member.

Further, the surface of the optical member of the present invention is the carbon-doped titanium oxide layer, which is blackened. In addition to obtaining sufficient blackening by doping with carbon, the hardness also increases, so that the surface state is ideal for an optical member.

In the optical member of the present invention, the carbon content in the carbon-doped titanium oxide layer is preferably 0.1 to 15 at%. When the carbon content is 0.1 at% or more, the surface can be blackened, and when 15 at% or less, excessive carbon doping that does not contribute to the surface blackening or the hardness increase can be suppressed.

Further, in the optical member of the present invention, it is preferable that the carbon is doped in the state of Ti-C bond. By doping carbon in the state of Ti-C bond, the surface hardness can be effectively increased.

Further, in the optical member of the present invention, it is preferable that the surface brightness index L* value is 40 or less. By setting the surface brightness index L* value to 40 or less, light reflection of various optical components can be sufficiently suppressed. Further, in the case of a pellicle frame, it is possible to easily and surely perform a foreign object non-adhesion inspection before use.

Further, in the optical member of the present invention, the reflectance is preferably 25% or less. By setting the reflectance to 25% or less, light reflection in various optical devices, pellicle frames, and the like can be sufficiently suppressed.

Further, in the optical member of the present invention, it is preferable that the linear expansion coefficient of the base member is 6 × 10⁻⁶ to 11 × 10⁻⁶ /K. By setting the linear expansion coefficient to 6 × 10⁻⁶ /K or more, the thermal expansion coefficient of the optical member and the thermal expansion coefficient of the material made of ceramic, silicon, or the like become close to each other. This makes it possible to reduce distortion and cracking caused by the difference in deformation between the optical member and the member made of ceramic, silicon, or the like due to thermal expansion when the temperature rises. Examples of combinations in which such an effect is achieved include a case where the optical member is a lens holder and the member made of ceramic, silicon, or the like is a lens such as a camera. Further, by setting the linear expansion coefficient to 11 × 10⁻⁶ /K or less, distortion at the time of temperature rise can be reduced.

Further, in the optical member of the present invention, it is preferable that the base member is an α + β type titanium alloy. For example, the Ti-6Al-4V alloy, which is a typical titanium alloy, is the α + β type titanium alloy, which can achieve both the mechanical properties such as strength and rigidity and the processing ability at a high level, and is a highly reliable optical member can be produced at low cost.

The present invention can also provide a method for producing an optical member according to claim 1.

The base member manufacturing step is a step where a base member made of titanium or a titanium alloy is processed into the shape of the optical member, and the processing method is not limited as long as a desired shape can be obtained, and various conventionally known processing methods can be used.

Further, the carbon-doping treatment step is a step for blackening or darkening the surface of the base member, and the surface can be blackened or darkened by forming the carbon-doped titanium oxide layer on the surface of the base member. Here, for example, though, when a titanium oxide layer is formed on the surface of the base member by surface oxidation in the atmosphere, the surface cannot be sufficiently blackened or darkened, a black titanium oxide layer doped with carbon can be formed under the combustion gas atmosphere of a gas containing a hydrocarbon as a main component by setting the surface temperature of the base member to 700 to 1500 °C.

In the method for producing an optical member of the present invention, it is preferable to include a polishing treatment step where the outermost surface of the carbon-doped titanium oxide layer is polished. There is a possibility that defects such as minute pores and cracks are generated on the outermost surface of the carbon-doped titanium oxide layer formed in the carbon-doped treatment step, but by polishing the outermost surface, only good carbon-doped titanium oxide layer without any defect can be used.

Here, in the lithography process, it is necessary to strictly suppress the generation of dust, and it is necessary to surely avoid the formation of a brittle region on the outermost surface of the pellicle frame. From this point of view, it is particularly preferable to polish the outermost surface of the carbon-doped titanium oxide layer in case that the optical member is a pellicle frame.

### Effects of the invention

According to the present invention, it is possible to provide a lightweight optical member that can be produced at a relatively low cost, wherein distortion due to temperature rise is suppressed, and the appearance color is sufficiently blackened or darkened, and a method for efficiently producing the optical member, and particularly, it is possible to provide a lightweight pellicle frame that can be manufactured at a relatively low cost, wherein distortion due to temperature rise is suppressed, and the appearance color is sufficiently blackened or darkened from the viewpoint of inspectability, and a method for efficiently producing the optical member.

### BRIEF DESCRIPTION OF THE DRAWINGS

FIG. 1 is a perspective view showing the pellicle frame of the present embodiment.
FIG. 2 is a C-C' cross-sectional view of the pellicle frame of the present embodiment.
FIG. 3 is a manufacturing step of the pellicle frame of the present embodiment.
FIG. 4 is a cross-sectional observation result (reflected electron composition image) of the optical member obtained in Example 1.
FIG. 5 is a cross-sectional observation result (reflected electron composition image) of the optical member obtained in Example 2.

### Embodiments for achieving the invention

Hereinafter, a pellicle frame will be taken up as a typical embodiment of the optical component, typical embodiments of the optical member and the manufacturing method thereof according to the present invention will be described in detail with reference to the drawings, but the present invention is not limited to only these examples. Further, the elements in the embodiment can be optionally combined with a part or the whole. In the following description, the same or equivalent parts are denoted by the same numerals, and there is a case that redundant explanation may be omitted. In addition, since the drawings are for conceptually explaining the present invention, dimensions of the respective constituent elements expressed and ratios thereof may be different from actual ones.

### 1. Pellicle frame

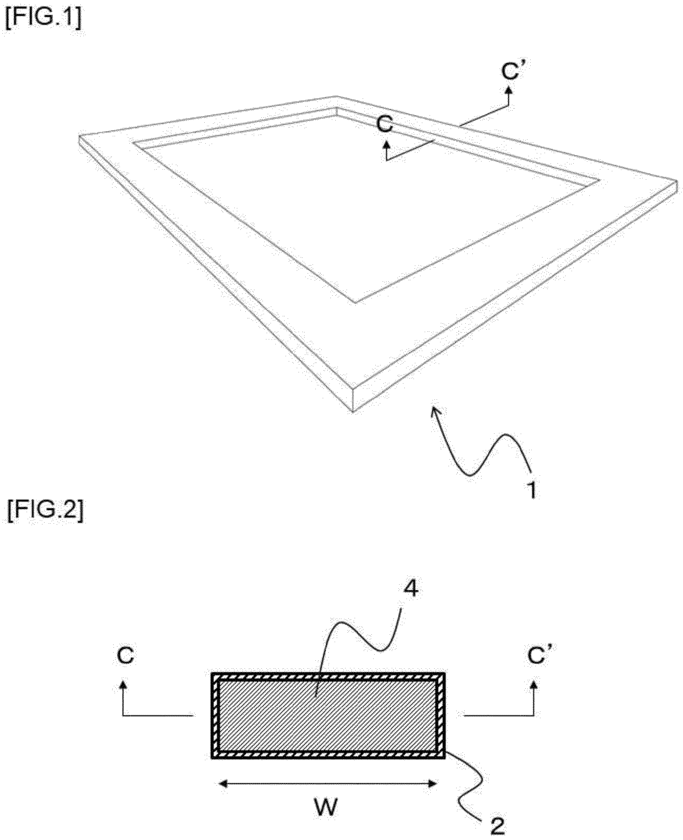

As shown in FIGS. 1 and 2, the pellicle frame 1 is constituted of a frame body 4 made of titanium or the titanium alloy having a carbon-doped titanium oxide layer 2 on the surface.

Since the frame body 4 is made of titanium or the titanium alloy, it has high strength and Young's modulus in comparison with a pellicle frame made of an aluminum alloy which is generally used in the past. Further, since the specific gravity of titanium and the titanium alloy is relatively light, about 4.5, the weight increase of the pellicle frame 1 can be suppressed.

The titanium alloy used for the frame body 4 can be Ti-6Al-4V alloy, Ti-6Al-6V-2Sn alloy, Ti-6Al-2Sn-4Zr-6Mo alloy, Ti-10V-2Fe-3Al alloy, Ti-7Al-4Mo alloy, Ti-5Al-2.5Sn alloy, Ti-6Al-5Zr-0.5Mo-0.2Si alloy, Ti-5.5Al-3.5Sn-3Zr-0.3Mo-1Nb-0.3Si alloy, Ti-8Al-1Mo-1V alloy, Ti-6Al-2Sn-4Zr-2Mo alloy, Ti-5Al-2Sn-2Zr-4Mo-4Cr alloy, Ti-11.5Mo-6Zr-4.5Sn alloy, Ti-15V-3Cr-3Al-3Sn alloy, Ti-15Mo-5Zr-3Al alloy, Ti-15Mo-5Zr alloy, or Ti-13V-11Cr-3Al alloy.

From the viewpoint of achieving both high strength and good processing ability, it is preferable to use an α + β type alloy, and further, from the viewpoint of material price and availability, it is more preferable to use a Ti-6Al-4V alloy. Further, though the principle is not always clear, when using the Ti-6Al-4V alloy, the surface can be more reliably blackened by forming the carbon-doped titanium oxide layer 2.

The shape of the pellicle frame 1 is not particularly limited as long as the effect of the present invention is not impaired, and various conventionally known shapes can be used depending on the shape of the light exposure original plate, and in general, the planar shape of the pellicle frame 1 is a ring shape, a rectangular shape, or a square shape, and has a size and a shape that cover a circuit pattern portion provided on the light exposure original plate.

The height (thickness) of the pellicle frame 1 is preferably 0.5 to 10 mm, more preferably 1 to 7 mm, and most preferably 1.0 to 3.0 mm. By setting the height (thickness) of the pellicle frame 1 to these values, deformation of the pellicle frame 1 can be suppressed and good handleability can be ensured.

The cross-sectional shape of the pellicle frame 1 is not particularly limited as long as the effect of the present invention is not impaired, and may be various conventionally known shapes, and preferable is a quadrilateral where the upper side and the lower side are parallel. The upper side of the pellicle frame 1 needs a width for stretching the pellicle film, and the lower side needs a width for providing an adhesive layer for adhesion and adhering to the light exposure original plate. For this reason, the width (W) of the upper side and the lower side of the pellicle frame 1 is preferably around 1 to 3 mm.

The flatness of the pellicle frame body 1 is preferably 30 µm or less, more preferably 20 µm or less. By improving the flatness of the pellicle frame 1, the amount of deformation of the light exposure original plate when the pellicle is attached to the light exposure original plate can be reduced. The flatness of the pellicle frame 1 is determined by measuring the height at four points at each corner of the pellicle frame 1 and four points at the center of the four sides, i.e. eight points in total, to calculate a virtual plane, and then calculating from a difference obtained by subtracting the lowest point from the highest point among the distances of each point from the virtual plane.

The carbon content in the carbon-doped titanium oxide layer 2 is preferably 0.1 to 15 at%. When the carbon content is 0.1 at% or more, the surface can be blackened, and when 15 at% or less, excessive carbon doping that does not contribute to the surface blackening or the hardness increase can be suppressed. With respect to the carbon content, more preferable content is 0.3 to 10 at%, and most preferable content is 1 to 5 at%. In the present specification, the carbon content means a value measured by the method described in Example.

Further, in the carbon-doped titanium oxide layer 2, it is preferable that the carbon is doped in the state of Ti-C bond. By doping carbon in the state of Ti-C bond, the surface hardness can be effectively increased, and the scratch resistance, wear resistance, and the like of the pellicle frame 1 can be improved. The surface hardness is preferably 500 Hv or more, more preferably 1000 Hv or more, and most preferably 1200 Hv or more.

The thickness of the carbon-doped titanium oxide layer 2 is preferably 10 nm or more, more preferably 50 nm or more, and most preferably 100 nm or more. By setting the thickness of the carbon-doped titanium oxide layer 2 to these values or more, not only the blackening of the surface can be achieved, but also scratch resistance and abrasion resistance can be ensured.

It is preferable that the surface brightness index L* value of the pellicle frame 1 is 40 or less. By setting the surface brightness index L* value of the surface to 40 or less, light reflection of various optical components can be sufficiently suppressed. Further, in the case of a pellicle frame, it is possible to easily and surely perform a foreign object non-adhesion inspection before use. With respect to the brightness index L* value, more preferable value is 35 or less, most preferable value is 30 or less. In the present specification, the brightness index L* value means a value measured by the method described in Example.

Further, the reflectance of the pellicle frame 1 is preferably 25% or less. By setting the reflectance to 25% or less, light reflection in various optical devices, pellicle frames, and the like can be sufficiently suppressed. More preferable reflectance is 20% or less, most preferable reflectance is 18% or less. The reflectance of the pellicle frame 1 described above is preferably satisfied at least in the range of 600 to 750 nm, more preferably satisfied in the range of 500 to 800 nm, further preferably satisfied in the range of 400 to 900 nm, and particularly preferably satisfied in the range of about 350 to 1000 nm. When the reflectance is satisfied within the above range, the reflected light including visible light is suppressed, and the optical observation of the optical member using the camera can be performed satisfactorily. In addition, in this specification, a reflectance means a value measured by the method described in Example.

Further, it is preferable that the linear expansion coefficient of the frame body 4 is 6 × 10⁻⁶ to 11 × 10⁻⁶ /K. By setting the linear expansion coefficient to 6 × 10⁻⁶ /K or more, the thermal expansion coefficient of the optical member and the thermal expansion coefficient of the material made of ceramic, silicon, or the like become close to each other. This makes it possible to reduce distortion and cracking caused by the difference in deformation between the optical member and the member made of ceramic, silicon, or the like due to thermal expansion when the temperature rises. Examples of combinations in which such an effect is achieved include a case where the optical member is a lens holder and the member made of ceramic, silicon, or the like is a lens such as a camera. Further, by setting the linear expansion coefficient to 11 × 10⁻⁶ /K or less, distortion at the time of temperature rise can be reduced. The more preferable linear expansion coefficient is 7 × 10⁻⁶ to 10 × 10⁻⁶ /K, and the most preferable linear expansion coefficient is 8 × 10⁻⁶ to 9 × 10⁻⁶ /K. In the present specification, the linear expansion coefficient represents a value in the temperature range of 0 to 100 °C. The linear expansion coefficient of the frame body 4 described above can be achieved, for example, when the frame body 4 is made of titanium or the titanium alloy.

### 2. Method for producing pellicle frame

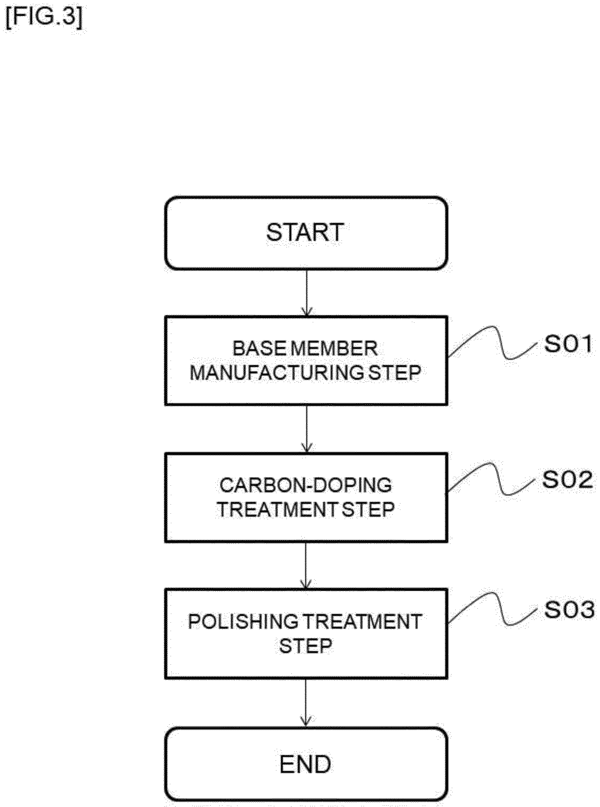

As shown in FIG. 3, the method for producing the pellicle frame of the present embodiment includes a base member manufacturing step (S01) where a base member made of titanium or a titanium alloy is processed into the shape of the optical member, and a carbon-doping treatment step (S02) where a carbon-doped titanium oxide layer is formed on the surface of the base member. Hereinafter, each step including any optional step will be described in detail.

### (1) Base member manufacturing step (S01)

The base member manufacturing step (S01) is a step for obtaining the frame body 4, and is a step for obtaining the frame body 4 of the pellicle frame 1 with high dimensional accuracy, as occasion demand, by subjecting the titanium or titanium alloy member to the joining and cutting process.

When the titanium or the titanium alloy material has a sufficient size, the frame body 4 can be cut out from the material. On the other hand, the frame body 4 can also be obtained by joining titanium or a titanium alloy members, and in this case, the yield of titanium or the titanium alloy member can be increased. Here, it is preferable to use solid-phase welding for joining the titanium or a titanium alloy members. By using the solid-phase welding, the strain generated at the joint portion can be suppressed, and the difference in mechanical properties between the joint portion and the base metal can be reduced. The frame body 4 obtained by cutting or joining may be further subjected to the cutting process.

### (2) Carbon-doping treatment step (S02)

The carbon-doping treatment step (S02) is a step for forming the carbon-doped titanium oxide layer 2 on the surface of the frame body 4 obtained in the base member manufacturing step (S01). According to the carbon-doping treatment step (S02), the appearance color of the pellicle frame 1 can be determined (it can be blackened).

As a pretreatment for the carbon-doping treatment step (S02), it is preferable to degreasing the frame body 4. Specifically, the frame body 4 can be washed with acetone or the like, then washed with pure water, and dried to remove the oil component.

The carbon-doped titanium oxide layer 2 can be formed on the surface of the frame body 4 by heat-treating the surface of the frame body 4 by bringing a combustion flame of a gas containing a hydrocarbon as a main component into contact with the surface so that the surface temperature becomes 700 to 1500 °C, or by heat-treating the surface in a combustion gas atmosphere of a hydrocarbon-based gas so that the surface temperature becomes 700 to 1500 °C. The temperature of the heat treatment is preferably 800 °C or higher, more preferably 900 °C or higher, preferably 1400 °C or lower, and more preferably 1300 °C or lower.

The treatment time of the heat treatment is not particularly limited as long as the carbon-doped titanium oxide layer 2 can be formed on the surface of the frame body 4, and is desirable that the peeling of the carbon-doped titanium oxide layer 2 can be suppressed at the time of cooling after heating. The heat treatment time is preferably 1 second or longer, more preferably 1 minute or longer, preferably 10 hours or shorter, and more preferably 1 hour or shorter.

Though, when a titanium oxide layer is formed on the surface of the base member 4 by surface oxidation in the atmosphere, the surface cannot be sufficiently blackened or darkened, a black titanium oxide layer doped with carbon can be formed by the heat treatment under the combustion gas atmosphere of a gas containing a hydrocarbon as a main component.

More specifically, it is preferable to use a combustion flame obtained by burning a fuel gas containing 50% by volume or more of a hydrocarbon, a combustion gas atmosphere obtained by burning a fuel gas containing 50% by volume or more of a hydrocarbon, or a fuel gas atmosphere containing 50% by volume or more of a hydrocarbon, and it is particularly preferable to use a reducing flame. When a fuel having a low hydrocarbon content is used, the amount of carbon doping may be insufficient or none at all, resulting in insufficient blackening. As the fuel gas containing 50% by volume or more of a hydrocarbon, there may be used, for example, a gas which contains a hydrocarbon such as natural gas, LPG, methane, ethane, propane, butane, ethylene, propylene, or acetylene, or a gas obtained by appropriately mixing these, and optionally mixing with air, hydrogen, oxygen and the like. The fuel gas containing 50% by volume or more of the hydrocarbon preferably contains 30% by volume or more of an unsaturated hydrocarbon, more preferably contains 50% by volume or more of acetylene, and the most preferably contains 100% of acetylene. When an unsaturated hydrocarbon, especially acetylene having a triple bond, is used, the unsaturated bond portion is decomposed in the process of combustion, especially in the reducing flame portion, to form an intermediate radical substance, and since this radical substance is highly active, it is considered that carbon doping is easily to occur.

When the surface layer of the frame body 4 to be heat-treated is titanium or the titanium alloy (when the oxide layer does not exist), oxygen for oxidizing titanium or the titanium alloy is required, and thus, it is necessary to contain air or oxygen in such an amount.

Here, in order to suppress the distortion of the frame body 4 due to the temperature rise, it is preferable to set the treatment temperature low as long as a good carbon-doped titanium oxide layer 2 can be obtained. For example, when the Ti-6Al-4V alloy is used, the β transus temperature at which αB phase transformation occurs in the alloy is about 980 °C, and when the temperature of the frame body 4 becomes equal to or higher than the β transus temperature due to the carbon doping treatment, the distortion is generated remarkably. Therefore, when using the Ti-6Al-4V alloy, it is preferable to perform the carbon doping treatment so that the surface temperature becomes 900 to 980 °C, and even when the surface temperature becomes higher, it is preferable that the region to be 980 °C or lower is present in the frame body 4.

The carbon content of the carbon-doped titanium oxide layer 2, the brightness index L* value and the reflectance of the surface of the frame body 4 can be controlled by the treatment conditions of the carbon-doping treatment step (S02), and it is preferable to adjust the gas composition, treatment temperature, treatment time, and the like so that the carbon content is 0.1 to 15 at%, the brightness index L* value is 40 or less and the reflectance is 25% or less.

### (3) Polishing treatment step (S03)

The method for producing the pellicle frame of the present embodiment preferably includes a polishing treatment step (SO3) where the outermost surface of the carbon-doped titanium oxide layer 2 is polished. There is a possibility that defects such as minute pores and cracks are generated on the outermost surface of the carbon-doped titanium oxide layer 2 formed in the carbon-doped treatment step (S02), but by polishing the outermost surface, only good carbon-doped titanium oxide layer 2 without any defect can be used.

Here, in the lithography process, it is necessary to strictly suppress the generation of dust, and it is necessary to surely avoid the formation of a brittle region on the outermost surface of the pellicle frame 1. From this point of view, it is particularly preferable to polish the outermost surface of the carbon-doped titanium oxide layer 2 in case that the optical member is a pellicle frame.

When polishing the surface of the carbon-doped titanium oxide layer 2, it is difficult to remove only the outermost surface in case that the polishing force is too strong. Here, for the polishing, it is preferable to gradually polish, for example, with a polishing material having a small polishing power such as beads where the periphery of the core glass is coated with gelatin. The amount of polishing is preferably about 1 µm from the outermost surface of the carbon-doped titanium oxide layer 2.

The representative embodiments of the present invention have been described above, but the present invention is not limited only to these embodiments, and various design changes are possible, and all such design changes are included in the technical scope of the present invention.

### 3. Optical member

In the above-described embodiment, the pellicle frame 1 has been illustrated as an optical member, but the optical member is not limited to this. Examples of the optical member include a pellicle frame, a lens holder, a barrel, a shade, a reflector and the like.

### EXAMPLES

### <Example 1>

A plate-shaped titanium base member was prepared by cutting out a titanium material having a thickness of 0.8 mm made of pure titanium.
The titanium base member was subjected to the carbon-doping treatment by heat-treating with a combustion flame of acetylene so that the surface temperature became 800 °C. As a result, the optical member of Example 1 was produced.

The cross section of the optical member of Example 1 was observed.

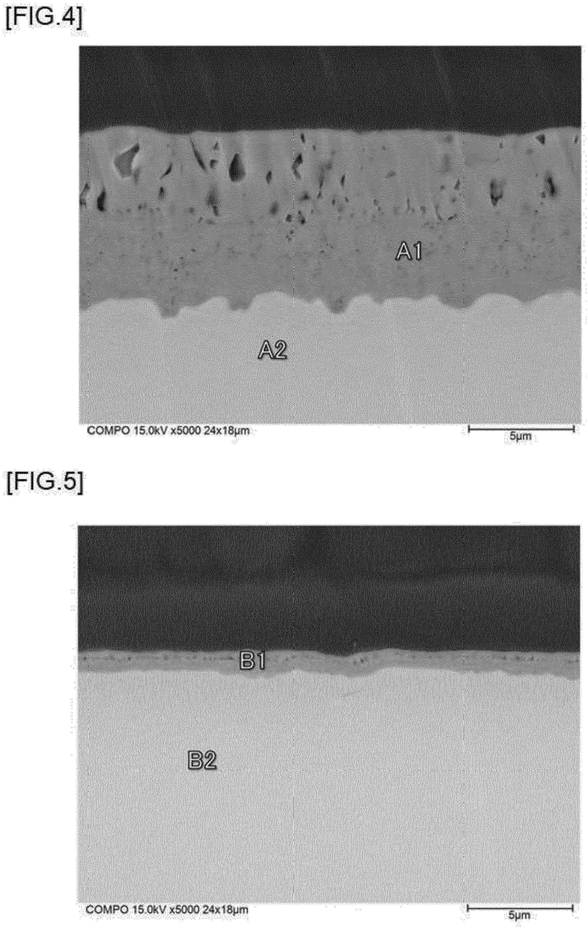

FIG. 4 shows the reflected electron composition image by SEM (ULTRA PLUS, available from Carl Zeiss). TABLE 1 shows the concentration (wt%) of each element and the carbon content (at%) of the carbon-doped titanium oxide layer obtained by using EPMA (EPMA-8050G, available from Shimadzu Corporation). In TABLE 1, the concentration of each element at each position indicated by reference symbol A1 and reference symbol A2 in FIG. 4 is shown. The carbon content was calculated from the concentration of each element.

The brightness index L* of the optical member of Example 1 was measured with a brightness measuring device (NF777, available from Nippon Denshoku Kogyo Co., Ltd.).
The thus obtained results are shown in TABLE 2.

The reflectance of the optical member of Example 1 was measured with a reflectance measuring device (Lambda750, available from PerkinElmer).
The thus obtained results are shown in TABLE 3.

The hardness of the surface of the optical member of Example 1 was measured with a Micro Vickers hardness tester (HM-221, available from Mitutoyo Co., Ltd.) under a load of 5 gf. The hardness was measured 5 times by changing the measurement position, and the average value of the 5 measurement values was taken as the hardness. The thus obtained results are shown in TABLE 4.

### <Example 2>

The optical member of Example 2 was produced in the same manner as in Example 1 except that the carbon-doping treatment was achieved by heat-treating so that the surface temperature of the titanium base member was 740 °C.

FIG. 5 shows a reflected electron composition image of the optical member of Example 2 obtained in the same manner as in Example 1. Further, the concentration (wt%) and carbon content (at%) of each element of the carbon-doped titanium oxide layer obtained in the same manner as in Example 1 are shown in TABLE 1, the brightness index L* is shown in TABLE 2, the reflectance is shown in TABLE 3, and the hardness is shown in TABLE 4. In TABLE 1, the concentration of each element at each position indicated by reference symbol B1 and reference symbol B2 in FIG. 5 is shown.

### <Comparative Example 1>

After producing the titanium base member in the same manner as in Example 1, the optical member of Comparative Example 1 having no carbon-doped titanium oxide layer as the surface layer was produced without performing the carbon-doping treatment.

The brightness index L*, the reflectance and the hardness of the surface layer (titanium oxide layer) measured in the same manner as in Example 1 are shown in TABLEs 2 to 4, respectively.

**[TABLE 1]**

| | | Concentration of element | | | | | | | | Carbon content (at%) |
|---|---|---|---|---|---|---|---|---|---|---|
| | | C | O | Na | Si | Ca | Ti | Cr | Fe | |
| Ex.1 | A1 | 0.2 | 45 | - | - | - | 55 | - | - | 0.4 |
| | A2 | - | 10 | - | - | - | 90 | - | - | 0.0 |
| Ex.2 | B1 | 5 | 38 | - | - | - | 57 | - | - | 11.0 |
| | B2 | - | 3 | - | - | - | 97 | - | - | 0.0 |

| | | | | | | | | | | |
|---|---|---|---|---|---|---|---|---|---|---|
| * In TABLE, symbol "-" means no detection | | | | | | | | | | |

**[TABLE 2]**

| | L* |
|---|---|
| Ex. 1 | 39.35 |
| Ex. 2 | 34.82 |
| Com, Ex.1 | 45.59 |

**[TABLE 3]**

| | | | | | | | | Reflectance [%] / wave length [nm] |
|---|---|---|---|---|---|---|---|---|
| Wave length [nm] | 350 | 400 | 500 | 600 | 700 | 800 | 900 | 1000 |
| Ex. 1 | 24.9 | 21.0 | 17.2 | 15.6 | 14.8 | 14.6 | 16.1 | 15.8 |
| Ex. 2 | 23.9 | 19.4 | 16.0 | 15.0 | 14.8 | 14.5 | 16.9 | 17.8 |
| Com. Ex. 1 | 35.8 | 37.7 | 39.9 | 43.7 | 46.9 | 48.7 | 50.1 | 50.4 |

**[TABLE 4]**

| | Hardness [Hv] |
|---|---|
| Ex. 1 | 1067 |
| Ex. 2 | 1219 |
| Com, Ex.1 | 405 |

From the observation results by SEM, it is clear that the optical member of Example 1 had at least two layers having different compositions. The distribution of the concentrations of the elements of oxygen and titanium obtained by EPMA is almost the same as the layer composition observed by SEM, and the oxygen concentration was high on the surface layer side and low on the lower layer side, whereas the titanium concentration was low on the surface layer side and high on the lower layer side. From this, it is found that in the optical member of Example 1, the surface of the base member made of titanium was oxidized. Furthermore, from the distribution of the concentration of the element of carbon and the value of the concentration at each position of the reference symbols A1 and A2, it is clear that the layer on the surface side has a carbon-doped titanium oxide layer. From these results, it is confirmed that the optical member of Example 1 had a carbon-doped titanium oxide layer on the surface of the base member made of titanium.

In the optical member of Example 2, the film thickness of the layer on the surface side is thinner than that of Example 1 from the results of the SEM and the distribution of the concentration of element, but it was found that the surface of the base member made of titanium was oxidized like in Example 1. Further, from the distribution of the concentration of the element of carbon and the value of the concentration at each position of the reference symbols B1 and B2, it is confirmed that, like in Example 1, the optical member of Example 2 had a carbon-doped titanium oxide layer on the surface of the base member made of titanium.

Further, as is clear from the results of TABLEs 2 and 3, the optical members of Examples 1 and 2 having a carbon-doped titanium oxide layer on the surface of the base member are the optical members which have the suppressed brightness index L* value and reflectance and the sufficiently darkened appearance color as compared with the optical member of Comparative Example 1 in which the surface is a layer made of titanium. Further, as is clear from the results in TABLE 4, the surface hardness of the optical members of Examples 1 and 2 was significantly improved as compared with the optical member of Comparative Example 1.

### Explanation of symbols

- 1:: Pellicle frame,
- 2:: Carbon-doped titanium oxide layer,
- 4:: Frame body.

## Claims

1. A method for producing an optical member (1), the method comprising:
a base member manufacturing step where a base member (4) made of titanium or a titanium alloy is processed into the shape of a pellicle frame, wherein the titanium alloy is (a) any of Ti-6Al-4V alloy, Ti-6Al-6V-2Sn alloy, Ti-6Al-2Sn-4Zr-6Mo alloy, Ti-10V-2Fe-3Al alloy, Ti-7Al-4Mo alloy, Ti-5Al-2.5Sn alloy, Ti-6Al-5Zr-0.5Mo-0.2Si alloy, Ti-5.5Al-3.5Sn-3Zr-0.3Mo-1Nb-0.3Si alloy, Ti-8Al-1Mo-1V alloy, Ti-6Al-2Sn-4Zr-2Mo alloy, Ti-5Al-2Sn-2Zr-4Mo-4Cr alloy, Ti-11.5Mo-6Zr-4.5Sn alloy, Ti-15V-3Cr-3Al-3Sn alloy, Ti-15Mo-5Zr-3Al alloy, Ti-15Mo-5Zr alloy, and Ti-13V-11Cr-3Al alloy, or (b) an α + β type alloy, and
a carbon-doping treatment step where a carbon-doped titanium oxide layer (2) is formed on the surface of the base member by heat-treating the surface of the base member by bringing a combustion flame of a gas containing a hydrocarbon as a main component into contact with the surface so that the surface temperature becomes 700 to 1500 °C, or by heat-treating the surface of the base member in a combustion gas atmosphere of a hydrocarbon-based gas so that the surface temperature becomes 700 to 1500 °C.

2. The method for producing an optical member (1) according to claim 1, further comprising a polishing treatment step where the outermost surface of the carbon-doped titanium oxide layer is polished.

3. An optical member (1) having the shape of a pellicle frame, which is produced by the method of claim 1 or 2, the optical member comprising:
a base member (4) made of titanium or a titanium alloy which is (a) any of Ti-6Al-4V alloy, Ti-6Al-6V-2Sn alloy, Ti-6Al-2Sn-4Zr-6Mo alloy, Ti-10V-2Fe-3Al alloy, Ti-7Al-4Mo alloy, Ti-5Al-2.5Sn alloy, Ti-6Al-5Zr-0.5Mo-0.2Si alloy, Ti-5.5Al-3.5Sn-3Zr-0.3Mo-1Nb-0.3Si alloy, Ti-8Al-1Mo-1V alloy, Ti-6Al-2Sn-4Zr-2Mo alloy, Ti-5Al-2Sn-2Zr-4Mo-4Cr alloy, Ti-11.5Mo-6Zr-4.5Sn alloy, Ti-15V-3Cr-3Al-3Sn alloy, Ti-15Mo-5Zr-3Al alloy, Ti-15Mo-5Zr alloy, and Ti-13V-11Cr-3Al alloy, or (b) an α + β type alloy, and
a carbon-doped titanium oxide layer (2) formed on the surface of the base member.

4. The optical member (1) according to claim 3, wherein the carbon content in the carbon-doped titanium oxide layer (2) is 0.1 to 15 at%.

5. The optical member (1) according to claim 3 or 4, wherein the carbon is doped in a state of Ti-C bond.

6. The optical member (1) according to any one of claims 3 to 5, wherein a surface brightness index L* value is 40 or less.

7. The optical member (1) according to any one of claims 3 to 6, wherein a reflectance is 25% or less.

8. The optical member (1) according to any one of claims 3 to 7, wherein a linear expansion coefficient of the base member (4) is 6 × 10⁻⁶ to 11 × 10⁻⁶ /K.

9. The optical member (1) according to any one of claims 3 to 8, wherein the base member (4) is an α + β type titanium alloy.

## Patentansprüche

1. Verfahren zur Herstellung eines optischen Elements (1), wobei das Verfahren Folgendes umfasst:
einen Basiselement-Herstellungsschritt, in dem ein Basiselement (4) aus Titan oder einer Titanlegierung in die Form eines Pellikelrahmens verarbeitet wird, wobei die Titanlegierung (a) eine beliebige aus einer Ti-6Al-4V-Legierung, Ti-6Al-6V-2Sn-Legierung, Ti-6Al-2Sn-4Zr-6Mo-Legierung, Ti-10V-2Fe-3Al-Legierung, Ti-7Al-4Mo-Legierung, Ti-5Al-2,5Sn-Legierung, Ti-6Al-5Zr-0.5Mo-0,2Si-Legierung, Ti-5,5Al-3,5Sn-3Zr-0,3Mo-1Nb-0,3Si-Legierung, Ti-8Al-1Mo-1V-Legierung, Ti-6Al-2Sn-4Zr-2Mo-Legierung, Ti-5Al-2Sn-2Zr-4Mo-4Cr-Legierung, Ti-11,5Mo-6Zr-4,5Sn-Legierung, Ti-15V-3Cr-3Al-3Sn-Legierung, Ti-15Mo-5Zr-3Al-Legierung, Ti-15Mo-5Zr-Legierung und Ti-13V-11Cr-3Al-Legierung oder (b) eine Legierung vom α+β-Typ ist, und
einen Kohlenstoffdotierungsschritt, in dem eine kohlenstoffdotierte Titanoxidschicht (2) auf der Oberfläche des Basiselements durch Wärmebehandeln der Oberfläche des Basiselements, indem eine Verbrennungsflamme eines Gases, das einen Kohlenwasserstoff als Hauptkomponente enthält, mit der Oberfläche in Kontakt gebracht wird, sodass eine Oberflächentemperatur von 700 bis 1.500 °C erreicht wird, oder durch Wärmebehandeln der Oberfläche des Basiselements unter einer Verbrennungsgasatmosphäre eines Gases auf Kohlenwasserstoffbasis, sodass eine Oberflächentemperatur von 700 bis 1.500 °C erreicht wird, gebildet wird.

2. Verfahren zur Herstellung eines optischen Elements (1) nach Anspruch 1, das weiters einen Polierbehandlungsschritt umfasst, in dem die äußerste Oberfläche der kohlenstoffdotierten Titanoxidschicht poliert wird.

3. Optisches Element (1), das die Form eines Pellikelrahmens aufweist, das durch ein Verfahren nach Anspruch 1 oder 2 hergestellt wird, wobei das optische Element Folgendes umfasst:
ein Basiselement (4) aus Titan oder einer Titanlegierung, die (a) eine beliebige aus einer Ti-6Al-4V-Legierung, Ti-6Al-6V-2Sn-Legierung, Ti-6Al-2Sn-4Zr-6Mo-Legierung, Ti-10V-2Fe-3Al-Legierung, Ti-7Al-4Mo-Legierung, Ti-5Al-2,5Sn-Legierung, Ti-6Al-5Zr-0.5Mo-0,2Si-Legierung, Ti-5,5Al-3,5Sn-3Zr-0,3Mo-1Nb-0,3Si-Legierung, Ti-8Al-1Mo-1V-Legierung, Ti-6Al-2Sn-4Zr-2Mo-Legierung, Ti-5Al-2Sn-2Zr-4Mo-4Cr-Legierung, Ti-11,5Mo-6Zr-4,5Sn-Legierung, Ti-15V-3Cr-3Al-3Sn-Legierung, Ti-15Mo-5Zr-3Al-Legierung, Ti-15Mo-5Zr-Legierung und Ti-13V-11Cr-3Al-Legierung oder (b) eine Legierung vom α+β-Typ ist, und
eine kohlenstoffdotierte Titanoxidschicht (2), die auf der Oberfläche des Basiselements gebildet ist.

4. Optisches Element (1) nach Anspruch 3, wobei der Kohlenstoffgehalt in der kohlenstoffdotierten Titanoxidschicht (2) 0,1 bis 15 Atom-% beträgt.

5. Optisches Element (1) nach Anspruch 3 oder 4, wobei der Kohlenstoff in einem Zustand einer Ti-C-Bindung dotiert ist.

6. Optisches Element (1) nach einem der Ansprüche 3 bis 5, wobei ein Oberflächenhelligkeitsindex-L*-Wert 40 oder weniger beträgt.

7. Optisches Element (1) nach einem der Ansprüche 3 bis 6, wobei eine Spiegelung 25 % oder weniger beträgt.

8. Optisches Element (1) nach einem der Ansprüche 3 bis 7, wobei ein linearer Ausdehnungskoeffizient des Basiselements (4) 6 x 10⁻⁶ bis 11 x 10⁻⁶/K beträgt.

9. Optisches Element (1) nach einem der Ansprüche 3 bis 8, wobei das Basiselement (4) eine Titanlegierung vom α+β-Typ ist.

## Revendications

1. Procédé de fabrication d'un élément optique (1), le procédé comprenant :
une étape de fabrication d'élément de base dans laquelle un élément de base (4) en titane ou en alliage de titane est traité sous la forme d'un cadre de pellicule, dans lequel l'alliage de titane est (a) un quelconque parmi un alliage Ti-6Al-4V, un alliage Ti-6Al-6V-2Sn, un alliage Ti-6Al-2Sn-4Zr-6Mo, un alliage Ti-10V-2Fe-3Al, un alliage Ti-7Al-4Mo, un alliage Ti-5Al-2,5Sn, un alliage Ti-6Al-5Zr-0,5Mo-0,2Si, un alliage Ti-5,5Al-3,5Sn-3Zr-0,3Mo-1Nb-0,3Si, un alliage Ti-8Al-1Mo-1V, un alliage Ti-6Al-2Sn-4Zr-2Mo, un alliage Ti-5Al-2Sn-2Zr-4Mo-4Cr, un alliage Ti-11,5Mo-6Zr-4,5Sn, un alliage Ti-15V-3Cr-3Al-3Sn, un alliage Ti-15Mo-5Zr-3Al, un alliage Ti-15Mo-5Zr et un alliage Ti-13V-11Cr-3Al, ou (b) un alliage de type α + β, et
une étape de traitement de dopage au carbone dans laquelle une couche d'oxyde de titane dopé au carbone (2) est formée sur la surface de l'élément de base en traitant thermiquement la surface de l'élément de base en amenant une flamme de combustion d'un gaz contenant un hydrocarbure en tant que composant principal en contact avec la surface de telle sorte que la température de surface passe de 700 à 1 500°C, ou en traitant thermiquement la surface de l'élément de base dans une atmosphère de gaz de combustion d'un gaz à base d'hydrocarbure de telle sorte que la température de surface passe de 700 à 1 500°C.

2. Procédé de production d'un élément optique (1) selon la revendication 1, comprenant en outre une étape de traitement de polissage dans laquelle la surface la plus à l'extérieure de la couche d'oxyde de titane dopé au carbone est polie.

3. Élément optique (1) présentant la forme d'un cadre de pellicule, qui, en utilisation, ne glisse contre aucun autre composant, et est produit par le procédé de la revendication 1 ou 2, l'élément optique comprenant :
un élément de base (4) constitué de titane ou d'un alliage de titane qui est (a) un quelconque parmi un alliage Ti-6Al-4V, un alliage Ti-6Al-6V-2Sn, un alliage Ti-6Al-2Sn-4Zr-6Mo, un alliage Ti-10V-2Fe-3Al, un alliage Ti-7Al-4Mo, un alliage Ti-5Al-2,5Sn, un alliage Ti-6Al-5Zr-0.5Mo-0.2Si, un alliage Ti-5,5Al-3.5Sn-3Zr-0,3Mo-1Nb-0.3Si, un alliage Ti-8Al-1Mo-1V, un alliage Ti-6Al-2Sn-4Zr-2Mo, un alliage Ti-5Al-2Sn-2Zr-4Mo-4Cr, un alliage Ti-11,5Mo-6Zr-4,5Sn, un alliage Ti-15V-3Cr-3Al-3Sn, un alliage Ti-15Mo-5Mo-5, et un alliage Ti-13Cr-3Al, ou (b)u liage de type α + β, et une couche d'oxyde de titane dopé au carbone (2) formée sur la surface de l'élément de base.

4. Élément optique (1) selon la revendication 3, dans lequel la teneur en carbone dans la couche d'oxyde de titane dopé au carbone (2) est de 0,1 à 15 % atomique.

5. Élément optique (1) selon la revendication 3 ou 4, dans lequel le carbone est dopé dans un état de liaison TiC.

6. Élément optique (1) selon l'une quelconque des revendications 3 à 5, dans lequel une valeur d'indice de luminosité de surface L* est de 40 ou moins.

7. Élément optique (1) selon l'une quelconque des revendications 3 à 6, dans lequel une réflectance est de 25 % ou moins.

8. Élément optique (1) selon l'une quelconque des revendications 3 à 7, dans lequel un coefficient de dilatation linéaire de l'élément de base (4) est de 6 x 10⁻⁶ à 11 x 10⁻⁶/K.

9. Élément optique (1) selon l'une quelconque des revendications 3 à 8, dans lequel l'élément de base (4) est un alliage de titane de type α + β.
